# FASCICULE DE BREVET EUROPEEN

(11) **EP 4 260 464 B1**
(45) Date de publication et mention de la délivrance du brevet: **16.07.2025**
(21) Numéro de dépôt: 21824551.2
(22) Date de dépôt: 03.12.2021
(51) Int. Cl.: H03K 17/965, H01H 21/22, H03K 17/967, B64C 13/04

(54) **BOUTON À PALETTE**
PADDELKNOPF
PADDLE BUTTON

(30) Priorité: 09.12.2020 FR 2012930
(43) Date de publication de la demande: 18.10.2023
(73) Titulaire: Crouzet, 26000 Valence (FR)
(72) Inventeur: CARTON, Hervé, 26000 Valence (FR); BEURDELEY, Damien, 26000 Valence (FR)
(74) Mandataire: INNOV-GROUP
(86) Numéro de dépôt international: PCT/EP2021/084107
(87) Numéro de publication internationale: WO 2022/122570

(56) Documents cités:
- EP-A1- 2 258 577
- WO-A1-2012/154188

## Description

L'invention concerne un bouton à palette ainsi qu'un procédé de fonctionnement de ce bouton à palette.

Les boutons à palette permettent de générer un signal en fonction de la position d'une palette le long d'une trajectoire. La palette est manuellement déplacée le long de cette trajectoire par un utilisateur.

Les boutons à palette font partie des interfaces homme-machine utilisées pour commander des équipements électriques. Lorsqu'un tel bouton à palette est intégré au tableau de bord d'un appareil pilotable tel qu'un avion ou un hélicoptère, il est particulièrement important d'obtenir un fonctionnement robuste de ce bouton. En effet, une panne du bouton peut alors avoir de graves conséquences. Par robuste, il faut comprendre robuste mécaniquement et dans l'information qu'il produit.

Pour accroître la robustesse de ce bouton vis-à-vis des pannes, différentes solutions sont connues. Selon une première solution, la position de la palette est mesurée par un premier et un second capteurs de position indépendants l'un de l'autre. Ainsi, si l'un de ces capteurs tombe en panne, l'autre capteur permet de pallier à cette défaillance. Par contre, si le déplacement de la palette est bloqué, les deux capteurs sont inopérants, alors le bouton n'est plus utilisable.

Pour pallier à cet inconvénient de la première solution, une seconde solution a été proposée. Cette seconde solution est identique à la première solution sauf que le bouton comporte une première et une seconde palettes déplaçables indépendamment l'une de l'autre le long de la trajectoire. La position de la première palette est mesurée par le premier capteur et la position de la seconde palette est mesurée par le second capteur. Les première et seconde palettes sont suffisamment rapprochées l'un de l'autre pour être simultanément déplacées à l'aide d'un seul doigt par l'utilisateur. En cas de blocage du déplacement de l'une de ces palettes, l'utilisateur peut continuer à utiliser le bouton en déplaçant seulement l'autre palette.

Par contre, lors de l'utilisation d'un tel bouton à deux palettes, il arrive que, accidentellement, l'utilisateur accroche une seule des deux palettes. Dans ce cas, l'une des palettes est déplacée et pas l'autre. Cela résulte en une incohérence entre les mesures des premier et second capteurs. Le calculateur électronique qui acquiert les mesures des premier et second capteurs ne sait pas, dans un tel cas, qu'elle est la mesure qui représente la véritable intention de l'utilisateur. Cela peut conduire à la génération d'une commande inattendue, et donc à un comportement imprévu de l'équipement piloté. Le calculateur peut également conclure à un défaut et engager une procédure adéquate.

De l'état de la technique est également connu de WO2012/154188A1 et EP2258577A1.

L'invention vise à remédier à au moins l'un de ces inconvénients. Elle a donc pour objet un bouton à palette conforme à la revendication 1.

L'invention a également pour objet un procédé de fonctionnement du bouton à palette conforme à la revendication 10.

L'invention sera mieux comprise à la lecture de la description qui va suivre, donnée uniquement à titre d'exemple non limitatif et faite en se référant aux dessins sur lesquels :
- la figure 1 est une illustration schématique d'un appareil équipé d'un bouton à palette ;
- la figure 2 est une illustration schématique d'un premier mode de réalisation du bouton à palette de la figure 1 ;
- la figure 3 est un organigramme d'un procédé de fonctionnement du bouton à palette de la figure 1 ;
- les figures 4 et 5 sont des illustrations schématiques, en coupe horizontale et partielle, de, respectivement, un deuxième et un troisième modes de réalisation du bouton à palette de la figure 1 ;
- la figure 6 est une vue de face et partielle d'un quatrième mode de réalisation du bouton à palette de la figure 1 ;
- la figure 7 est une illustration schématique et en vue de dessus du bouton de la figure 6.

Dans la suite de cette description, les caractéristiques et fonctions bien connues de l'homme du métier ne sont pas décrites en détail. Dans cette description, des exemples détaillés de mode de réalisation sont d'abord décrits dans un chapitre I en référence aux figures. Ensuite, dans un chapitre II, des variantes de ces modes de réalisation sont présentées. Enfin, les avantages des différents modes de réalisation sont présentés dans un chapitre III.

### Chapitre I : Exemples de modes de réalisation

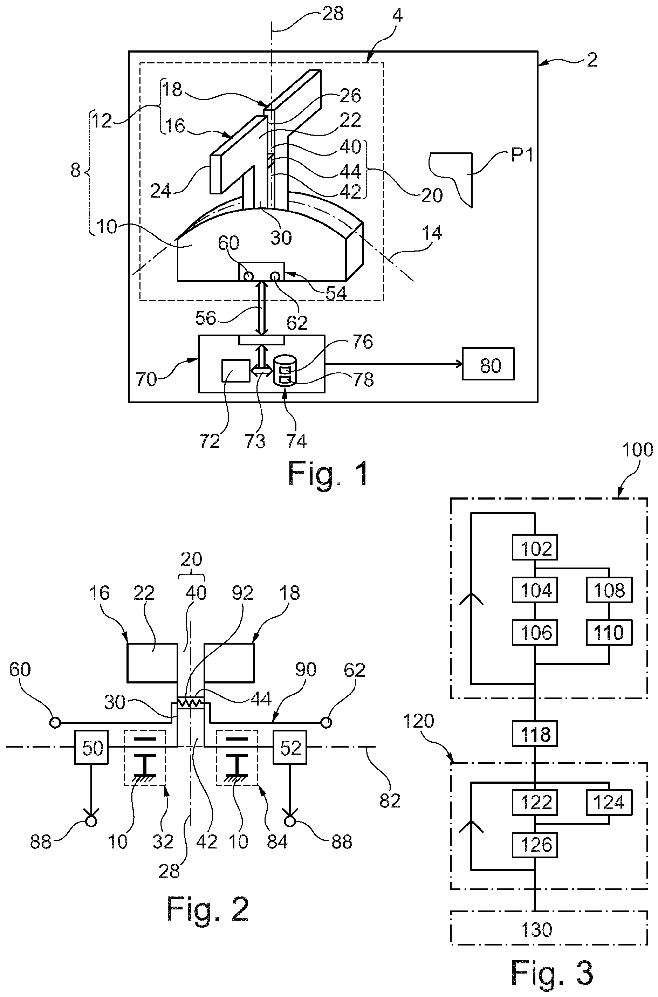

La figure 1 représente un appareil 2 pilotable par un utilisateur par l'intermédiaire d'une interface homme-machine 4. L'appareil 2 est par exemple un véhicule piloté par un être humain. L'appareil 2 peut être un avion, un hélicoptère, un véhicule automobile, un train, un bateau ou autre. Dans ce contexte, l'interface homme-machine doit être robuste vis-à-vis des défaillances.

L'interface homme-machine 4 est par exemple celle d'un cockpit d'avion ou d'hélicoptère. Pour simplifier la figure 1, seul un bouton 8 à palette de cette interface 4 est représenté.

Le bouton 8 comporte un châssis fixe 10 et un levier 12 déplaçable à la main par un utilisateur par rapport au châssis 10. Le châssis 10 est, par exemple, fixé sur un tableau de bord.

Le levier 12 est déplaçable de façon réversible entre une position rétractée et une position poussée. Dans ce mode de réalisation, le levier 12 est déplaçable à l'aide d'un seul doigt de la main de l'utilisateur. Sur la figure 1, le levier 12 est représenté dans une position intermédiaire, dans laquelle il s'étend principalement verticalement. Entre la position rétractée et la position poussée, la palette se déplace le long d'une trajectoire 14. Dans ce mode de réalisation, la trajectoire 14 est un arc de cercle.

Le levier 12 comporte deux palettes 16 et 18 mécaniquement raccordées l'une à l'autre par une zone dissociable 20. Dans ce mode de réalisation, les palettes 16 et 18 sont les symétriques l'une de l'autre par rapport à un plan vertical P1 contenant la trajectoire 14 et passant par la zone dissociable 20. Par conséquent, par la suite, seule la palette 16 est décrite plus en détail.

La palette 16 comporte une face avant d'appui 22 qui s'étend principalement dans un plan perpendiculaire à la trajectoire 14. La surface de la face avant 22 est conformée pour venir en appui sur une partie du doigt de l'utilisateur. À cet effet, sa surface est généralement supérieure à 1 cm². Pour limiter son encombrement, la surface de la face avant 22 est également généralement inférieure à 10 cm² ou 5 cm².

Du côté opposé à la face avant 22, la palette 16 comporte une face arrière 24. Par exemple, la face arrière 24 est le symétrique de la face avant 22 par rapport à un plan perpendiculaire à la trajectoire 14.

La palette 16 comporte aussi une face latérale 26 tournée du côté de la palette 18. La face latérale 26 s'étend, entre les faces avant 22 et arrière 24, principalement dans un plan parallèle au plan P1. La face latérale 26 est donc en vis-à-vis d'une face latérale correspondante de la palette 18 et séparée de cette palette 18 par une limite latérale 28 verticale. La limite 28 s'étend principalement verticalement dans le plan P1.

La palette 16 comporte aussi un pied 30 qui la raccorde mécaniquement à un mécanisme 32 (figure 2) de guidage. Le mécanisme 32 guide le déplacement de la palette 16 le long de la trajectoire 14. Ici, le mécanisme 32 est situé à l'intérieur du châssis 10.

De manière à être systématiquement et simultanément déplacées ensemble dans un mode de fonctionnement normal, les palettes 16 et 18 sont mécaniquement raccordées l'une à l'autre par l'intermédiaire de la zone dissociable 20. Cette zone 20 est dite « *dissociable* », car si le déplacement d'une des palettes 16, 18 est bloqué, alors en poussant avec son doigt seulement sur l'autre palette, la zone dissociable cède et les palettes 16 et 18 ne sont alors plus mécaniquement raccordées l'une à l'autre. Lorsque les palettes 16 et 18 ne sont plus mécaniquement raccordées l'une à l'autre, le mode de fonctionnement du bouton 8 est dit « *dégradé* »*.*

La zone dissociable 20 est conçue pour rester intègre, c'est-à-dire pour ne pas céder, tant que la différence entre les forces d'appui exercées par l'utilisateur sur les faces avant des palettes 16 et 18 n'excède pas un seuil prédéterminé S₁. Ici, ce seuil S₁ est supérieur ou égal à 2Fₘᵢₙ ou 3Fₘᵢₙ, où Fₘᵢₙ est égale à la force minimale que doit exercer l'utilisateur sur les faces avant des palettes 16, 18 pour déplacer le levier 12 de sa position rétractée jusqu'à sa position poussée dans le mode de fonctionnement normal. Typiquement, dans le cas de palettes déplacées à l'aide d'un seul doigt, la force Fₘᵢₙ est comprise entre 0,5 N et 10 N, et le plus souvent entre 1 N et 7 N ou entre 3 N et 7 N.

Le seuil S₁ est aussi habituellement inférieur à 10Fₘᵢₙ ou 5Fₘᵢₙ, et de préférence inférieure à 4Fᵣₘᵢₙ. Ainsi, la force à exercer par l'utilisateur pour passer du mode de fonctionnement normal au mode de fonctionnement dégradé n'est pas trop élevée.

Dans ce premier mode de réalisation, les palettes 16 et 18 et la zone dissociable 20 forment un seul et même bloc de matière. Dans ce cas, la zone 20 est une zone sécable. Ainsi, les palettes 16 et 18 et la zone dissociable 20 peuvent être fabriquées par moulage à l'aide d'un seul et même moule comportant l'empreinte en creux de ces palettes 16 et 18, et de la zone 20. Pour cela, la zone 20 est formée d'un seul tenant avec les palettes. Plus précisément, elle est formée par des évidements réalisés dans le bloc de matière le long de la limite 28. À titre d'illustration, sur la figure 1, la zone 20 comporte :
- un évidement supérieur 40 ;
- un évidement inférieur 42 ;
- un bras horizontal 44 qui raccorde mécaniquement les palettes 16 et 18 entre elles.

Ici, les évidements 40 et 42 sont délimités de chaque côté par les faces latérales des palettes 16 et 18. Dans ce mode de réalisation, les évidements 40 et 42 traversent complètement l'épaisseur du bloc de matière dans lequel sont réalisées les palettes 16 et 18. Ces évidements 40 et 42 forment donc des fentes.

De préférence, la largeur horizontale de l'évidement 40 est petite pour que le doigt de l'utilisateur puisse simultanément venir en appui sur les faces avant des palettes 16 et 18. Typiquement, la largeur de l'évidement 40 est inférieure à 5 mm et, de préférence, inférieure à 1 mm ou 0,5 mm.

Les évidements 40 et 42 sont séparés l'un de l'autre dans la direction verticale par le bras de matière 44. Ici, ce bras 44 forme une poutre qui s'étend horizontalement depuis la face latérale de la palette 16 jusqu'à la face latérale de la palette 18. La section transversale du bras 44 est dimensionnée pour se rompre lorsque la différence entre les forces d'appui exercées sur les faces avant des palettes 16 et 18 atteint le seuil S₁. À cet effet, le matériau utilisé pour réaliser les palettes 16, 18 et la zone 20 est un matériau cassant, c'est-à-dire qu'il se rompt brusquement dès que la contrainte de cisaillement dans le bras 44 atteint la valeur S₁/S_{U}, où :
- S_{U} est la surface de la section transversale du bras 44, et
- S₁ est le seuil, en newton, à partir duquel la zone 20 cède.

Par exemple, le matériau utilisé est du plastique dur ou de la céramique.

La position angulaire des palettes 16 et 18 le long de la trajectoire 14 est mesurée par des capteurs 50, 52 (figure 2) de position. Ces capteurs 50 et 52 sont fixés dans le châssis 10.

Le bouton 8 comporte aussi une interface 54 qui raccorde le bouton 8 à un réseau 56 de transmission d'informations. Plus précisément, le bouton 8 transmet sur ce réseau 56 les mesures des positions angulaires des palettes 16 et 18. Dans ce mode de réalisation, le bouton 8 est aussi capable de transmettre sur ce réseau 56 une information qui indique si la zone dissociable 20 a cédé ou non. À cet effet, le bouton 8 comporte deux bornes électriques 60 et 62.

Un calculateur électronique 70 est raccordé au réseau 56 pour traiter les mesures et les informations délivrées par le bouton 8. À cet effet, il comporte typiquement :
- un micro-processeur 72 ;
- une mémoire non volatile 74 comportant les instructions exécutées par le micro-processeur 72 ;
- un bus 73 de transmission d'informations qui raccorde la mémoire 74 au micro-processeur 72.

La mémoire 74 comporte ici les instructions :
- d'un module 76 de commande d'équipements en fonction de la position des palettes 16 et 18, et
- d'un module 78 de diagnostic de défaillance du bouton 8.

Ici, l'appareil 2 comporte un équipement commandable 80. Le module 76 commande l'équipement 80 en fonction de la position angulaire des palettes 16 et 18. Le module 78 est apte à communiquer à un agent de maintenance, par l'intermédiaire d'une interface homme-machine, une éventuelle défaillance du bouton 8.

La figure 2 représente schématiquement l'architecture interne du bouton 8. Ici, le mécanisme 32 de guidage est une liaison pivot qui autorise seulement le déplacement en rotation de la palette 16 autour d'un axe horizontal 82.

La palette 18 est mécaniquement raccordée au châssis 10 par son propre mécanisme 84 de guidage. Ainsi, dans le mode de fonctionnement dégradé, la palette 18 peut être déplacée le long de la trajectoire 14 indépendamment de la palette 16. Ici, le mécanisme 84 est structuralement identique au mécanisme 32. Il permet donc la rotation de la palette 18 autour de l'axe 82.

Comme illustré sur la figure 2, le capteur 50 mesure la position angulaire de la palette 16, tandis que le capteur 52 mesure la position angulaire de la palette 18. Le capteur 50 est apte à fonctionner indépendamment du capteur 52 et vice-versa. Ainsi, dans le mode de fonctionnement dégradé, le capteur 50 mesure la position angulaire de la palette 16 indépendamment de la position angulaire de la palette 18. Réciproquement, dans le mode de fonctionnement dégradé, le capteur 52 mesure la position angulaire de la palette 18 indépendamment de la position angulaire de la palette 16. Dans le mode de fonctionnement normal, les capteurs 50 et 52 mesurent la même position angulaire, au jeu de fonctionnement prêt. Ainsi, dans le mode de fonctionnement normal, ils sont redondants. Dès lors, même si l'un de ces capteurs tombe en panne, l'autre capteur permet de continuer à mesurer et à transmettre la position du levier 12. À cet effet, la palette 16 est mécaniquement raccordée seulement au capteur 50, tandis que la palette 18 est mécaniquement raccordée seulement au capteur 52.

Les capteurs 50 et 52 délivrent leurs mesures respectives sur des bornes 86, 88 de l'interface 54 (figure 2).

Dans ce mode de réalisation, le bouton 8 comporte aussi une liaison électrique 90 qui raccorde électriquement entre elles les bornes 60 et 62. Une partie 92 de cette liaison 90 est mécaniquement attachée à la zone dissociable 20 pour que, lorsque cette zone cède, cela entraîne également la coupure de la partie 92. Lorsque la partie 92 est coupée, les bornes 60 et 62 sont électriquement isolées l'une de l'autre. Ainsi, la conductivité électrique entre les bornes 60 et 62 présente une première valeur dans le mode de fonctionnement normal et bascule vers une seconde valeur, plus faible, dans le mode de fonctionnement dégradé.

Par exemple, la partie 92 est un ruban de matériau électriquement conducteur fixé sur le bras 44. Ce ruban s'étend d'une extrémité à l'autre de ce bras. Ainsi, quand le bras 44 est rompu, cela déchire ce ruban et coupe la liaison électrique 90.

Le fonctionnement du bouton 8 va maintenant être décrit en référence au procédé de la figure 3.

Le procédé débute par une phase 100 durant laquelle le bouton est dans son mode de fonctionnement normal. Dans ce mode de fonctionnement normal, les palettes 16 et 18 sont mécaniquement reliées l'une à l'autre par la zone 20. Lorsque l'utilisateur appuie avec son doigt simultanément sur les deux faces avant des palettes 16 et 18 ou sur une seule de ses faces avant, les palettes 16 et 18 se déplacent systématiquement ensemble le long de la trajectoire 14. Ainsi, les positions angulaires des palettes 16 et 18 le long de la trajectoire 14 sont systématiquement égales. Autrement dit, l'écart entre les positions angulaires des palettes 16 et 18 est ici systématiquement égal à zéro. De plus, dans le mode de fonctionnement normal, les bornes 60 et 62 sont électriquement raccordées entre elles.

Lors d'une étape 102, les capteurs 50 et 52 mesurent les positions angulaires, respectivement, des palettes 16 et 18 et transmettent ces mesures, par l'intermédiaire du réseau 56, au calculateur 70.

Lors de cette étape 102, la conductivité électrique entre les bornes 60 et 62 est également transmise au calculateur 70.

En réponse, lors d'une étape 104, le module 76 traite ces mesures et transmet une commande établie en fonction de ces mesures à l'équipement 80.

Lors d'une étape 106, l'équipement 80 exécute la commande reçue.

En parallèle, lors d'une étape 108, en cas de défaillance d'un des capteurs 50, 52, le module 76 détecte cette défaillance et déclenche l'exécution d'une étape 110 corrective. Ici, le module 78 détecte une défaillance lorsque l'un des capteurs ne transmet plus de mesure. Il détecte aussi une défaillance si l'écart entre les mesures des capteurs 50 et 52 franchit un seuil prédéterminé S₂ alors que la conductivité électrique acquise pour la liaison 90 reste égale à sa première valeur.

Lorsque le capteur défaillant peut être identifié, l'étape corrective 110 consiste, par exemple, à utiliser seulement les mesures du capteur non-défaillant lors de l'étape 104. Un capteur est identifié comme étant défaillant lorsqu'il ne transmet plus de mesure ou lorsqu'il transmet des mesures qui sont en dehors d'une plage de mesures plausibles. Si le capteur défaillant ne peut pas être identifié, l'étape 110 consiste alors, par exemple, à inhiber l'étape 104 et à déclencher une alarme pour signaler ce dysfonctionnement.

Les boutons tels que le bouton 8 sont aussi sujets à des défaillances mécaniques telles que le blocage, par exemple par un corps étranger, du déplacement de l'une des palettes 16 ou 18.

Dans ce cas, en réponse, l'utilisateur pousse plus fort que d'habitude sur la palette qui n'est pas bloquée. Par la suite, on suppose que c'est la palette 18 qui est la seule palette à être bloquée. Lorsque la force d'appui exercée sur la palette 16 dépasse le seuil S₁, en réponse, la zone 20 cède lors d'une étape 118. Le mode de fonctionnement du bouton 8 bascule alors du mode de fonctionnement normal vers son mode de fonctionnement dégradé.

Lors d'une phase 120, le bouton est utilisé dans ce mode de fonctionnement dégradé. Lors de cette phase 120, l'utilisateur peut continuer à utiliser le bouton 8, mais en déplaçant seulement la palette 16.

Plus précisément, lors d'une étape 122, les capteurs 50 et 52 mesurent la position angulaire des palettes 16 et 18. Cette étape 122 est, par exemple, identique à l'étape 102. Lors de l'étape 122, la conductivité électrique entre les bornes 60 et 62 transmise au calculateur 70, prend la seconde valeur plus petite que la première valeur.

En parallèle, lors d'une étape 124, le module 78 détecte que la conductivité électrique entre les bornes 60 et 62 est égale à la seconde valeur. En réponse, il identifie la palette qui est bloquée. Par exemple, pour cela, la palette qui est identifiée comme étant bloquée est celle dont la position angulaire reste constante, alors que dans le même temps, la position angulaire de l'autre palette varie.

Puis, lors d'une étape 126, le module 76 traite les mesures seulement de la palette non-bloquée, c'est-à-dire ici de la palette 16, et transmet une commande à l'équipement 80 établie uniquement à partir de la position angulaire mesurée de la palette 16.

Ensuite, pendant toute la durée du mode de fonctionnement dégradé, les étapes 122 et 126 sont réitérées en boucle pour chaque nouvelle mesure acquise du capteur 50, afin de commander l'équipement 80 à partir seulement de la position angulaire de la palette 16. Lors de ces réitérations des étapes 122 et 126, l'étape 124 n'est plus exécutée puisque la palette bloquée a déjà été identifiée.

La phase 126 de fonctionnement en mode dégradé est ici suivie par une phase 130 de maintenance. Lors de cette phase 130, le module 78 transmet, par l'intermédiaire d'une interface homme-machine, l'information selon laquelle la palette 18 du bouton 8 est bloquée. L'interface homme-machine affiche alors cette information pour la communiquer à l'agent de maintenance. Dès lors, cet agent de maintenance est en mesure de réparer la défaillance du bouton 8.

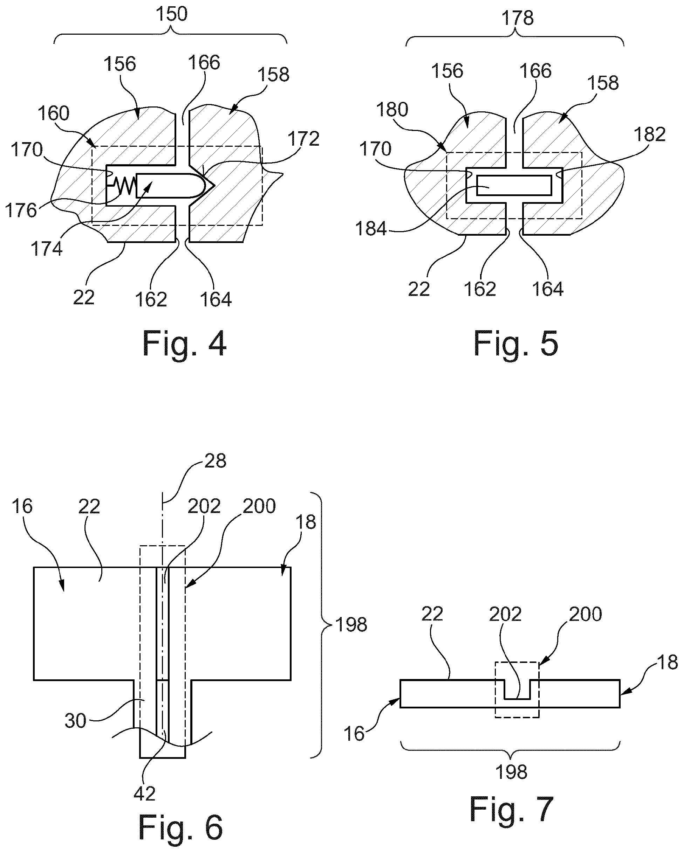

La figure 4 représente un bouton 150 à palette. Ce bouton 150 est identique au bouton 8 sauf que :
- les palettes 16 et 18 sont remplacées par des palettes, respectivement, 156 et 158, et
- la zone dissociable 20 est remplacée par une zone dissociable 160.

Ici, pour simplifier la figure 4, seule une coupe horizontale partielle du bouton 150 est représentée. Cette coupe est effectuée le long d'un plan de coupe horizontal qui est perpendiculaire aux faces avant des palettes 156 et 158 et qui traverse ces faces avant.

Les palettes 156 et 158 sont identiques aux palettes 16 et 18, sauf qu'elles sont mécaniquement séparées l'une de l'autre. À cet effet, elles comportent chacune une face latérale, respectivement 162 et 164, en vis-à-vis l'une de l'autre et qui s'étend sur toute la hauteur de la palette. Ces faces latérales 162, 164 s'étendent principalement dans un plan perpendiculairement au plan contenant la face avant de ces palettes. L'espace creux entre les faces latérales 162 et 164 forme une fente traversante 166.

La zone dissociable 160 comporte :
- un trou borgne 170 creusé dans la palette 156 et qui débouche dans la face latérale 162,
- un logement 172 creusé dans la face latérale 164 en vis-à-vis du trou borgne 170,
- un pion 174 ou une bille reçu à l'intérieur du trou borgne 170,
- un ressort 176 qui sollicite en permanence le pion 174 en dehors du trou borgne 170.

Le pion 174 est déplaçable, en coulissant à l'intérieur du trou borgne 170, entre une position saillante, représentée sur la figure 4, et une position escamotée. Dans la position saillante, l'extrémité distale du pion 174 est reçue à l'intérieur du logement 172. Dans cette position saillante, le pion 174 autorise uniquement un déplacement simultané des palettes 156 et 158.

Dans la position escamotée, l'extrémité distale du pion 174 n'est plus reçue à l'intérieur du logement 172. Dans cette position escamotée, le pion 174 autorise le déplacement d'une palette indépendamment de l'autre palette.

Au moins l'un du logement 172 et de l'extrémité distale du pion 174 comporte un pan incliné apte à transformer la différence entre les forces d'appui exercées par l'utilisateur sur les faces avant des palettes 156, 158, en une force horizontale qui repousse le pion 174 vers l'intérieur du trou borgne 170 à l'encontre de la force de rappel du ressort 176. La raideur du ressort 176 est choisie pour que le pion 174 atteigne sa position escamotée uniquement lorsque la différence entre les forces d'appui exercées par l'utilisateur sur les faces avant des palettes 156, 158 dépasse le seuil S₁.

De préférence, dans ce mode de réalisation, le pion 174 est réalisé dans un matériau qui ne casse pas lorsque la zone 160 cède. De plus, la zone dissociable 160 comporte un mécanisme de retenu du pion 174 à l'intérieur du trou 170. Ce mécanisme retient le pion 174 à l'intérieur du trou 170 même lorsque la face latérale 164 n'est plus en face de la face latérale 162.

Le fonctionnement du bouton 150 se déduit des explications données pour le bouton 8. De plus, le fonctionnement du bouton 150 présente la particularité suivante. Cette particularité apparaît, par exemple, dans le cas où le blocage de la palette 158 est un blocage qui l'empêche d'atteindre la position poussée mais qui ne l'empêche pas d'atteindre la position rétractée. Dans ce cas, lorsque la palette 156 revient de la position poussée vers la position rétractée, elle croise la palette 158. À ce moment, le pion 174 revient dans le logement 172. Ainsi, sur le reste de la trajectoire vers la position rétractée, les palettes 156, 158 sont de nouveau déplacées simultanément.

La figure 5 représente un bouton 178 identique au bouton 150, sauf que la zone 160 est remplacée par une zone dissociable 180. La zone dissociable 180 est identique à la zone dissociable 160 sauf que :
- le logement 172 est remplacé par un trou borgne 182 ;
- le pion 174 est remplacé par un pion 184 ;
- le ressort 176 est omis.

Dans ce mode de réalisation, les trous borgnes 170, 182 sont configurés pour engendrer une contrainte de cisaillement dans le pion 184 lorsque l'utilisateur appuie sur l'une des palettes alors que l'autre palette est bloquée. Par exemple, contrairement au mode de réalisation de la figure 4, le trou borgne 182 est dépourvu de pan incliné propre à générer une force horizontale qui déplace le pion 184 en translation à l'intérieur de ces trous borgnes 170, 182.

Dans ce mode de réalisation, le pion 184 est réalisé dans un matériau cassant. Plus précisément, le pion 184 est apte à rompre dès que la différence entre les forces d'appui exercées par l'utilisateur sur les faces avant des palettes 156, 158 dépasse le seuil S₁. Par exemple, le pion 184 est réalisé en céramique ou en plastique dur. Ici, le pion 184 est mécaniquement distinct des palettes 156 et 158.

Les figures 6 et 7 représentent un bouton 198 identique au bouton 8, sauf que la zone dissociable 20 est remplacée par une zone dissociable 200. La zone 200 est identique à la zone 20, sauf que l'évidement 40 et le bras 44 sont remplacés par un évidement 202 non-traversant. L'évidement 202 forme ici une rainure qui s'étend le long de la limite 28 et forme un amincissement de matières dans le bloc de matière dans lequel sont réalisées les palettes 16 et 18. Ici, la profondeur de l'évidement 202 est ajustée pour que la zone 200 cède dès que la différence entre les forces d'appui exercées par l'utilisateur sur les faces avant des palettes 16 et 18 dépasse le seuil S₁.

### Chapitre Il : Variantes :

D'autres modes de réalisation de la zone dissociable sont possibles. Par exemple, la zone dissociable 160 est remplacée par une zone dissociable réalisée à l'aide d'un premier et d'un second aimants permanents. Les premier et second aimants permanents sont fixés, sans aucun degré de liberté, sur, respectivement, les première et seconde palettes 156 et 158. Dans le mode de fonctionnement normal, le pôle Sud du premier aimant est collé sur le pôle Nord du second aimant permanent de manière à assurer une liaison rigide entre les palettes 156, 158 tant que la différence entre les forces d'appui exercées par l'utilisateur sur les faces avant de ces palettes ne dépasse pas le seuil S₁. Lorsque la différence entre les forces d'appui exercées par l'utilisateur sur les faces avant des première et seconde palettes dépasse ce seuil S₁, alors la force de cisaillement est suffisante pour décoller le premier aimant du second aimant permanent. La zone dissociable cède alors. Ainsi, si par exemple, c'est la première palette qui est bloquée et ne peut plus être déplacée, la seconde palette peut être déplacée de sa position rétractée vers sa position poussée. Lorsque la seconde palette revient de la position poussée vers la position rétractée, elle croise la première palette. À ce moment, les premier et second aimants permanents se collent à nouveau. Ainsi, sur le reste de la trajectoire vers la position rétractée, les première et seconde palettes sont de nouveau déplacées simultanément. Dans ce mode de réalisation, le basculement entre le mode de fonctionnement normal et le mode de fonctionnement dégradé est réversible comme dans le mode de réalisation de la figure 4.

L'évidement 202 peut aussi être réalisé sur la face arrière des palettes 16 et 18.

En variante, dans le mode de fonctionnement normal, l'écart entre les positions des première et seconde palettes le long de la trajectoire 14 n'est pas nul. Dans ce cas, il existe un écart constant entre ces positions.

En variante, le bouton à palette comporte un mécanisme de rappel qui ramène automatiquement le bouton vers sa position rétractée dès que l'utilisateur ne touche plus au levier 12.

Dans un mode de réalisation simplifié, la liaison électrique 90 est omise. Dans ce cas, les bornes 60 et 62 peuvent également être omises.

Dans un mode de réalisation simplifié, la liaison électrique 90 est présente et l'information selon laquelle sa partie 92 est coupée, est remontée via le bus 56. Pour cela, par exemple, le module 76 est implémentée dans le bouton 8 et non pas dans le calculateur 70. Dans ce cas, les bornes 60 et 62 peuvent également être omises.

La trajectoire 14 le long de laquelle se déplacent les palettes peut être différente d'un arc de cercle. Par exemple, en variante, cette trajectoire est une trajectoire rectiligne ou ayant toute autre forme appropriée. Par exemple, dans un mode réalisation particulier, les palettes sont déplaçables, par l'utilisateur, le long d'une trajectoire rectiligne confondue avec l'axe 28 et non pas le long de la trajectoire 14. Dans ce cas, le bouton à palette fonctionne comme un bouton poussoir. Dans le mode de fonctionnement normal, les deux palettes sont simultanément enfoncées. Dans le mode de fonctionnement dégradé, il est possible de continuer à utiliser le bouton en enfonçant qu'une seule des deux palettes.

D'autres formes et dimensions sont possibles pour les palettes. Par exemple, dans un mode de réalisation particulier, les palettes sont destinées à être déplacées, non pas à l'aide d'un seul doigt, mais à l'aide de plusieurs doigts ou encore à l'aide d'une ou des deux mains de l'utilisateur ou à l'aide du pied de l'utilisateur. Dans chacun de ces cas, les dimensions des palettes doivent être adaptées à l'usage envisagé. Lorsqu'une palette est destinée à être poussée par la main de l'utilisateur, la force Fₘᵢₙ peut être comprise entre 30 N et 150 N et, le plus souvent, entre 30 N et 100 N.

En variante les capteurs 50 et 52 sont remplacés par des capteurs tout ou rien qui indiquent seulement si la palette a atteint ou non sa position poussée.

### Chapitre III : Avantages des modes de réalisation décrits :

La zone dissociable permet de garantir que lors du mode de fonctionnement normal, les deux palettes sont systématiquement déplacées en parallèle. Cela évite donc qu'un écart accidentel apparaisse entre les positions des première et seconde palettes. Ainsi tout fonctionnement inattendu de l'équipement 80 commandé est évité.

De plus, puisque l'écart entre les mesures des deux capteurs est systématiquement constant pendant la phase de fonctionnement normal, une variation de l'écart entre les positions mesurées par ces capteurs est un indicateur fiable d'une défaillance du bouton.

Le bouton décrit ici présente également l'avantage de pouvoir être aussi utilisé dans un mode de fonctionnement dégradé dans lequel une seule des palettes est utilisée. Cela est rendu possible par le fait que chaque palette est déplaçable indépendamment de l'autre et par le fait que l'utilisateur peut facilement amener la zone dissociable à céder et donc à libérer le déplacement d'une des palettes par rapport à l'autre.

Cela accroît la robustesse du bouton vis-à-vis des pannes telles que le blocage accidentel du déplacement d'une des palettes. En effet, dans ce cas, le bouton reste quand même utilisable, en déplaçant seulement la palette qui n'est pas bloquée.

De plus, ce bouton est aussi tolérant vis-à-vis d'un dysfonctionnement d'un des capteurs, car dans ce cas, la position est mesurée par l'autre capteur.

La rupture de la liaison électrique 90 lorsque la zone dissociable cède permet d'indiquer simplement et de façon fiable au calculateur 70 qu'une défaillance s'est produite. Le module 78 peut alors identifier simplement la pièce à remplacer.

Le fait de former les deux palettes 16, 18 et la zone dissociable 20 dans le même bloc de matière simplifie la fabrication du bouton 8. Par exemple, les deux palettes et la zone dissociable peuvent alors être réalisées à l'aide d'un seul moule et d'une seule opération de moulage.

La réalisation de la zone dissociable à l'aide d'un pion cassant 184, distinct des palettes 156 et 158, permet de remplacer le pion cassé par un nouveau pion intègre sans avoir pour cela à remplacer systématiquement ces deux palettes 156, 158.

La réalisation de la zone dissociable à l'aide du pion 174 permet aussi de restaurer le raccordement mécanique entre les deux palettes 156 et 158 sans nécessairement remplacer au moins l'une de ces palettes.

## Revendications

1. Bouton à palette actionnable par un utilisateur, ce bouton comportant :
- une première palette (16; 156) et une seconde palette (18; 158) apte chacune à se déplacer parallèlement à une trajectoire commune (14), entre une position rétractée et une position poussée lorsque l'utilisateur appui sur au moins l'une de ces palettes,
- un premier capteur (50) apte à mesurer la position de la première palette le long de la trajectoire commune indépendamment de la position de la seconde palette le long de cette trajectoire commune,
- un second capteur (52) apte à mesurer la position de la seconde palette le long de la trajectoire commune indépendamment de la position de la première palette le long de cette trajectoire commune,
**caractérisé en ce que** :
- les première et seconde palettes (16, 18; 156, 158) sont mécaniquement attachées l'une à l'autre uniquement par l'intermédiaire d'une zone dissociable (20; 160; 180; 200) pour autoriser uniquement un déplacement simultané des première et seconde palettes tant qu'aucun blocage de l'une des palettes par rapport à l'autre n'intervient,
- cette zone dissociable est apte à céder dès que la différence entre les forces d'appui exercées, respectivement, sur les première et seconde palettes, dépasse un seuil prédéterminé, ce seuil prédéterminé étant ajusté pour être franchi par appui de l'utilisateur sur l'une des palettes alors que le déplacement de l'autre des palettes est bloquée, et
- lorsque la zone dissociable a cédé, la première palette (16; 156) et la seconde palette (18; 158) sont dissociées l'une de l'autre, c'est-à-dire que la zone dissociable ne raccorde plus mécaniquement les première et seconde palettes ensemble de sorte que la second palette est déplaçable, par l'utilisateur, entre ses positions rétractée et poussée indépendamment de la première palette parallèlement à la trajectoire commune.

2. Bouton selon la revendication 1, dans lequel le bouton comporte :
- deux bornes électriques (60, 62) apte à être raccordées à un module (78) de diagnostique de défaillance, et
- une liaison électrique (90) qui raccorde électriquement les bornes électriques entre elles, une partie (92) de cette liaison électrique étant attachée à la zone dissociable pour être coupée quand la zone dissociable cède.

3. Bouton selon l'une quelconque des revendications précédentes, dans lequel :
- le bouton comporte un seul et même bloc de matière dans lequel sont formées les première et seconde palettes (16, 18),
- les première et seconde palettes comportent chacune une face d'appui (22), les faces d'appui de chacune des palettes s'étendant, l'une à côté de l'autre, principalement dans un plan perpendiculaire à la trajectoire commune et étant chacune situées d'un côté respectif d'une limite latérale (28),
- la zone dissociable (20; 200) comprend un ou plusieurs évidements (40, 42; 202) réalisés, dans le bloc de matière, le long de la limite latérale pour entraîner la rupture du bloc de matière le long de cette limite latérale dès que la différence entre les forces d'appui exercées, respectivement, sur les première et seconde palettes, dépasse le seuil prédéterminé.

4. Bouton selon l'une quelconque des revendications 1 à 2, dans lequel :
- les première et seconde palettes (156, 158) comportent chacune :
- une face d'appui, les faces d'appui de chacune des palettes s'étendant l'une à côté de l'autre principalement dans un plan perpendiculaire à la trajectoire,
- une face latérale (162, 164) qui s'étend principalement perpendiculairement à la face d'appui, les faces latérales de chacune des palettes étant tournées l'une vers l'autre et séparée l'une de l'autre par une fente traversante (166), et
- la zone dissociable (180) comporte :
- un premier trou (170) réalisé dans la face latérale (162) de la première palette et un second trou (182) réalisé dans la face latérale (164) de la seconde palette en vis-à-vis du premier trou,
- un pion (184), mécaniquement distinct des première et seconde palettes, ce pion comportant une extrémité reçue dans le premier trou et une extrémité opposée reçue dans le second trou pour raccorder mécaniquement entre elles les première et seconde palettes et autoriser uniquement un déplacement simultané des première et seconde palettes tant qu'aucun blocage de l'une des palettes par rapport à l'autre n'intervient, ce pion étant réalisé dans un matériau cassant apte à rompre dès que la différence entre les forces d'appui exercées, respectivement, sur les première et seconde palettes, dépasse le seuil prédéterminé.

5. Bouton selon l'une quelconque des revendications 1 à 2, dans laquelle :
- les première et seconde palettes (156, 158) comportent chacune :
- une face d'appui, les faces d'appui de chacune des palettes s'étendant l'une à côté de l'autre principalement dans un plan perpendiculaire à la trajectoire,
- une face latérale (162, 164) qui s'étend principalement perpendiculairement à la face d'appui, les faces latérales de chacune des palettes étant tournées l'une vers l'autre et séparée l'une de l'autre par une fente traversante (166), et
- la zone dissociable (160) comporte :
- un trou borgne (170) débouchant dans la face latérale (162) de la première palette et un logement (172) creusé, en vis-à-vis, dans la face latérale (164) de la seconde palette,
- un pion (174) comportant une extrémité distale tournée vers la face latérale de la seconde palette, ce pion étant apte à coulisser à l'intérieur du trou borgne entre :
- une position saillante dans laquelle son extrémité distale est reçue à l'intérieur du logement pour raccorder mécaniquement entre elles les première et seconde palettes et autoriser uniquement un déplacement simultané des première et seconde palettes tant qu'aucun blocage de l'une des palettes par rapport à l'autre n'intervient, et
- une position escamotée à l'intérieur du trou borgne dans laquelle le pion autorise le déplacement, par l'utilisateur, de l'une des palettes indépendamment de l'autre des palettes,
- un ressort (176) qui sollicite en permanence le pion vers sa position saillante et qui autorise le déplacement du pion vers sa position escamotée uniquement lorsque la différence entre les forces d'appui exercées, respectivement, sur les première et seconde palettes, dépasse le seuil prédéterminé.

6. Bouton selon l'une quelconque des revendications précédentes, dans lequel la zone dissociable (20; 160; 180; 200) est apte à résister, et donc à ne pas céder, tant que la force d'appui exercée par l'utilisateur sur l'une des palettes alors que le déplacement de l'autre des palettes est bloqué, ne dépasse pas 2Fₘᵢₙ, où Fₘᵢₙ est la force minimale que l'utilisateur doit exercer sur les palettes pour les déplacer simultanément de leurs positions rétractées vers leurs positions poussées.

7. Bouton selon l'une quelconque des revendications précédentes, dans lequel la zone dissociable (20; 160; 180; 200) est apte à céder dès que la force d'appui exercée par l'utilisateur sur l'une des palettes alors que le déplacement de l'autre des palettes est bloquée, dépasse 5Fₘᵢₙ, où Fₘᵢₙ est la force minimale que l'utilisateur doit exercer sur les palettes pour les déplacer simultanément de leurs positions rétractées vers leurs positions poussées.

8. Bouton selon la revendication 6 ou 7, dans lequel la force Fₘᵢₙ est comprise entre 0,5N et 10N.

9. Bouton selon la revendication 6 ou 7, dans lequel la force Fₘᵢₙ est comprise entre 30N et 150N.

10. Procédé de fonctionnement d'un bouton conforme à l'une quelconque des revendications précédentes, dans lequel :
- lors d'une phase de fonctionnement normal (100), la zone dissociable raccorde mécaniquement les deux palettes ensemble de sorte que, lorsque l'utilisateur appuie sur au moins l'une des deux palettes, les deux palettes se déplacent systématiquement simultanément entre leurs positions rétractées et leurs positions poussées,
- en cas de blocage du déplacement de la première palette et en réponse à une force d'appui exercée par l'utilisateur uniquement sur la seconde palette, la zone dissociable cède (20; 160; 180 ; 200) et le bouton bascule dans une phase de fonctionnement dégradée,
- lors de la phase de fonctionnement dégradée (120), la zone dissociable ne raccorde plus mécaniquement les deux palettes ensemble de sorte que la second palette est déplaçable, par l'utilisateur, entre ses positions rétractée et poussée indépendamment de la première palette.

## Patentansprüche

1. Von einem Benutzer betätigbarer Palettenknopf, wobei der Knopf umfasst :
- eine erste Palette (16; 156) und eine zweite Palette (18; 158), die sich jeweils parallel zu einer gemeinsamen Bahn (14) zwischen einer eingezogenen Position und einer gedrückten Position bewegen können, wenn der Benutzer auf mindestens eine dieser Paletten drückt,
- einen ersten Sensor (50), der dazu geeignet ist, die Position der ersten Palette entlang der gemeinsamen Bahn unabhängig von der Position der zweiten Palette entlang dieser gemeinsamen Bahn zu messen,
- einen zweiten Sensor (52), der geeignet ist, die Position der zweiten Palette entlang des gemeinsamen Weges unabhängig von der Position der ersten Palette entlang dieses gemeinsamen Weges zu messen,
**dadurch gekennzeichnet, dass** :
- die erste und die zweite Palette (16, 18; 156, 158) mechanisch nur über einen trennbaren Bereich (20; 160; 180; 200) aneinander befestigt sind, um nur eine gleichzeitige Bewegung der ersten und der zweiten Palette zuzulassen, solange keine Blockierung einer der Paletten in Bezug auf die andere auftritt,
- die trennbare Zone nachgeben kann, sobald die Differenz zwischen den auf die erste bzw. zweite Palette ausgeübten Auflagekräften einen vorbestimmten Schwellenwert überschreitet, wobei dieser vorbestimmte Schwellenwert so eingestellt ist, dass er durch das Drücken des Benutzers auf eine der Paletten überschritten wird, während die Bewegung der anderen der Paletten blockiert ist, und
- wenn der lösbare Bereich nachgegeben hat, die erste Palette (16; 156) und die zweite Palette (18; 158) voneinander getrennt werden, d.h. der lösbare Bereich die erste und zweite Palette nicht mehr mechanisch miteinander verbindet, so dass die zweite Palette vom Benutzer zwischen ihrer eingezogenen und geschobenen Position unabhängig von der ersten Palette parallel zur gemeinsamen Bahn bewegt werden kann .

2. Knopf nach Anspruch 1, wobei der Knopf umfasst :
- zwei elektrische Anschlüsse (60, 62), die geeignet sind, mit einem Fehlerdiagnosemodul (78) verbunden zu werden, und
- eine elektrische Verbindung (90), die die elektrischen Anschlüsse elektrisch miteinander verbindet, wobei ein Teil (92) dieser elektrischen Verbindung an dem trennbaren Bereich angebracht ist, um unterbrochen zu werden, wenn der trennbare Bereich nachgibt.

3. Knopf nach einem der vorhergehenden Ansprüche, wobei :
- der Knopf einen einzigen Materialblock umfasst, aus dem die ersten und zweiten Paletten (16, 18) geformt sind,
- die ersten und zweiten Paletten jeweils eine Auflagefläche (22) aufweisen, wobei sich die Auflageflächen jeder der Paletten nebeneinander hauptsächlich in einer Ebene senkrecht zur gemeinsamen Bahn erstrecken und sich jeweils auf einer jeweiligen Seite einer seitlichen Begrenzung (28) befinden,
- der trennbare Bereich (20; 200) eine oder mehrere Ausnehmungen (40, 42; 202) umfasst, die in dem Materialblock entlang der seitlichen Begrenzung ausgebildet sind, um den Materialblock entlang dieser seitlichen Begrenzung zum Brechen zu bringen, sobald die Differenz zwischen den auf die erste bzw. zweite Palette ausgeübten Auflagekräften den vorbestimmten Schwellenwert überschreitet.

4. Knopf nach einem der Ansprüche 1 bis 2, wobei :
- die ersten und zweiten Paletten (156, 158) jeweils :
- eine Auflagefläche, wobei sich die Auflageflächen jeder der Paletten nebeneinander hauptsächlich in einer Ebene senkrecht zum Pfad erstrecken,
- eine Seitenfläche (162, 164), die sich hauptsächlich senkrecht zur Auflagefläche erstreckt, wobei die Seitenflächen jeder der Paletten einander zugewandt und durch einen durchgehenden Schlitz (166) voneinander getrennt sind, und
- der dissoziierbare Bereich (180) umfasst :
- ein erstes Loch (170), das in der Seitenfläche (162) der ersten Palette ausgebildet ist, und ein zweites Loch (182), das in der Seitenfläche (164) der zweiten Palette gegenüber dem ersten Loch ausgebildet ist,
- einen Stift (184), der mechanisch von der ersten und der zweiten Palette getrennt ist, wobei dieser Stift ein in dem ersten Loch aufgenommenes Ende und ein entgegengesetztes, in dem zweiten Loch aufgenommenes Ende aufweist, um die erste und die zweite Palette mechanisch miteinander zu verbinden und nur eine gleichzeitige Bewegung der ersten und der zweiten Palette zuzulassen, solange keine Blockierung einer der Paletten in Bezug auf die andere auftritt, Dieser Stift ist aus einem spröden Material gefertigt, das brechen kann, sobald die Differenz zwischen den jeweils auf die erste und zweite Palette ausgeübten Auflagekräften den vorbestimmten Schwellenwert überschreitet.

5. Knopf nach einem der Ansprüche 1 bis 2, wobei :
- die ersten und zweiten Paletten (156, 158) jeweils :
- eine Auflagefläche, wobei sich die Auflageflächen jeder der Paletten nebeneinander hauptsächlich in einer Ebene senkrecht zum Pfad erstrecken,
- eine Seitenfläche (162, 164), die sich hauptsächlich senkrecht zur Auflagefläche erstreckt, wobei die Seitenflächen jeder der Paletten einander zugewandt und durch einen durchgehenden Schlitz (166) voneinander getrennt sind, und
- der trennbare Bereich (160) umfasst :
- ein Sackloch (170), das in die Seitenfläche (162) der ersten Palette mündet, und eine Aufnahme (172), die gegenüberliegend in die Seitenfläche (164) der zweiten Palette eingearbeitet ist,
- einen Stift (174) mit einem distalen Ende, das der Seitenfläche der zweiten Palette zugewandt ist, wobei dieser Stift geeignet ist, im Inneren des Sacklochs zu gleiten zwischen :
- einer vorspringenden Position, in der sein distales Ende im Inneren der Aufnahme aufgenommen wird, um die erste und die zweite Palette mechanisch miteinander zu verbinden und nur eine gleichzeitige Bewegung der ersten und der zweiten Palette zuzulassen, solange keine Blockierung einer der Paletten in Bezug auf die andere auftritt, und
- eine versenkte Position innerhalb des Sacklochs, in der der Stift die Bewegung einer der Paletten unabhängig von der anderen der Paletten durch den Benutzer zulässt,
- eine Feder (176), die den Stift ständig in seine vorstehende Position drückt und die Bewegung des Stifts in seine versenkte Position nur dann zulässt, wenn die Differenz zwischen den auf die erste bzw. zweite Palette ausgeübten Auflagekräften den vorbestimmten Schwellenwert überschreitet.

6. Knopf nach einem der vorhergehenden Ansprüche, bei dem der trennbare Bereich (20; 160; 180; 200) in der Lage ist, Widerstand zu leisten und somit nicht nachzugeben, solange die vom Benutzer auf eine der Paletten ausgeübte Druckkraft, während die Bewegung der anderen Paletten blockiert ist, 2Fₘᵢₙnicht überschreitet, wobei Fₘᵢₙdie minimale Kraft ist, die der Benutzer auf die Paletten ausüben muss, um sie gleichzeitig aus ihren eingezogenen Positionen in ihre gedrückten Positionen zu bewegen.

7. Knopf nach einem der vorhergehenden Ansprüche, bei dem der trennbare Bereich (20; 160; 180; 200) nachgeben kann, sobald die vom Benutzer auf eine der Paletten ausgeübte Druckkraft, während die Bewegung der anderen Palette blockiert ist, 5Fₘᵢₙüberschreitet, wobei Fₘᵢₙdie Mindestkraft ist, die der Benutzer auf die Paletten ausüben muss, um sie gleichzeitig aus ihren eingefahrenen Positionen in ihre geschobenen Positionen zu bewegen.

8. Knopf nach Anspruch 6 oder 7, wobei die Kraft Fₘᵢₙzwischen 0,5N und 10N liegt.

9. Knopf nach Anspruch 6 oder 7, wobei die Kraft Fₘᵢₙzwischen 30N und 150N liegt.

10. Verfahren zum Betreiben eines Knopfes nach einem der vorhergehenden Ansprüche, bei dem :
- in einer normalen Betriebsphase (100) der trennbare Bereich die beiden Schaufeln mechanisch miteinander verbindet, so dass, wenn der Benutzer auf mindestens eine der beiden Schaufeln drückt, sich die beiden Schaufeln systematisch gleichzeitig zwischen ihren zurückgezogenen Positionen und ihren gedrückten Positionen s bewegen,
- im Falle einer Blockierung der Bewegung der ersten Palette und als Reaktion auf eine vom Benutzer ausschließlich auf die zweite Palette ausgeübte Druckkraft die trennbare Zone nachgibt (20; 160; 180; 200) und der Knopf in eine verschlechterte Funktionsphase umschaltet,
- in der verschlechterten Betriebsphase (120) der trennbare Bereich die beiden Paletten nicht mehr mechanisch miteinander verbindet, so dass die zweite Palette durch den Benutzer unabhängig von der ersten Palette zwischen ihrer eingezogenen und ihrer geschobenen Position bewegt werden kann.

## Claims

1. User-operated paddle button with :
- a first pallet (16; 156) and a second pallet (18; 158), each able to move parallel to a common trajectory (14), between a retracted position and a pushed position when the user presses on at least one of these pallets,
- a first sensor (50) capable of measuring the position of the first pallet along the common path independently of the position of the second pallet along this common path,
- a second sensor (52) capable of measuring the position of the second pallet along the common path independently of the position of the first pallet along this common path,
**characterised in that** :
- the first and second pallets (16, 18; 156, 158) are mechanically attached to each other solely by means of a detachable zone (20; 160; 180; 200) to allow only simultaneous movement of the first and second pallets as long as one of the pallets is not locked relative to the other,
- this dissociable zone is capable of giving way as soon as the difference between the bearing forces exerted on the first and second pallets, respectively, exceeds a predetermined threshold, this predetermined threshold being adjusted so as to be crossed by the user bearing on one of the pallets while the movement of the other of the pallets is blocked, and
- when the dissociable zone has given way, the first pallet (16; 156) and the second pallet (18; 158) are dissociated from each other, i.e. the dissociable zone no longer mechanically connects the first and second pallets together so that the second pallet can be moved, by the user, between its retracted and pushed positions independently of the first pallet parallel to the common path .

2. A button according to claim 1, wherein the button comprises :
- two electrical terminals (60, 62) suitable for connection to a fault diagnosis module (78), and
- an electrical link (90) which electrically connects the electrical terminals together, a part (92) of this electrical link being attached to the dissociable zone so as to be cut when the dissociable zone gives way.

3. A button according to any one of the preceding claims, wherein :
- the button comprises a single block of material from which the first and second pallets (16, 18) are formed,
- the first and second pallets each have a bearing face (22), the bearing faces of each of the pallets extending, side by side, mainly in a plane perpendicular to the common path and each being located on a respective side of a lateral boundary (28),
- the separable zone (20; 200) comprises one or more recesses (40, 42; 202) made in the block of material along the lateral boundary to cause the block of material to break along this lateral boundary as soon as the difference between the bearing forces exerted on the first and second pallets respectively exceeds a predetermined threshold.

4. A button according to any one of claims 1 to 2, wherein :
- the first and second pallets (156, 158) each comprise :
- a bearing face, the bearing faces of each of the pallets extending side by side mainly in a plane perpendicular to the trajectory,
- a side face (162, 164) which extends substantially perpendicular to the support face, the side faces of each of the pallets facing each other and separated from each other by a through slot (166), and
- the dissociable zone (180) comprises :
- a first hole (170) made in the side face (162) of the first pallet and a second hole (182) made in the side face (164) of the second pallet opposite the first hole,
- a pin (184), mechanically distinct from the first and second pallets, this pin having one end received in the first hole and an opposite end received in the second hole to mechanically connect the first and second pallets together and only allow simultaneous movement of the first and second pallets as long as one of the pallets is not locked relative to the other, this pin being made of a brittle material capable of breaking as soon as the difference between the bearing forces exerted on the first and second pallets respectively exceeds a predetermined threshold.

5. A button according to any one of claims 1 to 2, wherein :
- the first and second pallets (156, 158) each comprise :
- a bearing face, the bearing faces of each of the pallets extending side by side mainly in a plane perpendicular to the trajectory,
- a side face (162, 164) which extends substantially perpendicular to the support face, the side faces of each of the pallets facing each other and separated from each other by a through slot (166), and
- the dissociable zone (160) comprises :
- a blind hole (170) opening out in the side face (162) of the first pallet and a housing (172) hollowed out, opposite, in the side face (164) of the second pallet,
- a pin (174) having a distal end turned towards the side face of the second pallet, this pin being able to slide inside the blind hole between :
- a protruding position in which its distal end is received inside the housing to mechanically connect the first and second pallets together and allow only simultaneous movement of the first and second pallets as long as one of the pallets is not locked relative to the other, and
- a retracted position inside the blind hole in which the pin allows the user to move one of the pallets independently of the other,
- a spring (176) which permanently biases the pin towards its protruding position and which allows the pin to move towards its retracted position only when the difference between the bearing forces exerted on the first and second vanes respectively exceeds a predetermined threshold.

6. Button according to any one of the preceding claims, in which the dissociable zone (20; 160; 180; 200) is capable of resisting, and therefore of not giving way, as long as the bearing force exerted by the user on one of the pallets while the movement of the other of the pallets is blocked, does not exceed 2Fₘᵢₙ, where Fₘᵢₙis the minimum force that the user must exert on the pallets to move them simultaneously from their retracted positions to their pushed positions.

7. Button according to any one of the preceding claims, in which the dissociable zone (20; 160; 180; 200) is capable of giving way as soon as the bearing force exerted by the user on one of the pallets while the movement of the other of the pallets is blocked, exceeds 5Fₘᵢₙ, where Fₘᵢₙis the minimum force that the user must exert on the pallets to move them simultaneously from their retracted positions to their pushed positions.

8. Button according to claim 6 or 7, wherein the force Fₘᵢₙis between 0.5N and 10N.

9. Button according to claim 6 or 7, wherein the force Fₘᵢₙis between 30N and 150N.

10. A method of operating a button in accordance with any one of the preceding claims, wherein :
- during a normal operating phase (100), the separable zone mechanically connects the two pallets together so that, when the user presses on at least one of the two pallets, the two pallets systematically move simultaneously between their retracted positions and their pushed positions s,
- if the movement of the first pallet is blocked and in response to a pressure exerted by the user solely on the second pallet, the separable zone gives way (20; 160; 180; 200) and the button switches to a degraded operating phase,
- during the degraded operating phase (120), the separable zone no longer mechanically connects the two pallets together so that the second pallet can be moved by the user between its retracted and pushed positions independently of the first pallet.
